# EUROPEAN PATENT SPECIFICATION

(11) **EP 1 348 782 B1**
(45) Date of publication and mention of the grant of the patent: **30.06.2010**
(21) Application number: 03000080.6
(22) Date of filing: 08.01.2003
(51) Int. Cl.: C30B 15/10

(54) **Process for surface modifying a quartz glass crucible**
Verfahren zur Modifikation der Oberfläche eines Quarzglastiegels
Procédé pour la modification de la surface d'un creuset en quartz

(30) Priority: 29.03.2002 JP 2002094542; 30.05.2002 JP 2002157231
(43) Date of publication of application: 01.10.2003
(73) Proprietor: Japan Super Quartz Corporation, Akita-shi Akita 010-0065 (JP)
(72) Inventor: Tsujimoto, Toshio, R&D Center, Akita-shi, Akita 010-0065 (JP); Tsuji, Yoshiyuki, R&D Center, Akita-shi, Akita 010-0065 (JP)
(74) Representative: HOFFMANN EITLE

(56) References cited:
- WO-A-94/24505
- JP-A- 8 002 932
- US-A- 5 976 247

## Description

### BACKGROUND OF THE INVENTION

### FIELD OF THE INVENTION

The present invention relates to a process for surface modifying a quartz glass crucible, the surface modified crucible being used in the process of pulling up silicon single crystal used for a semiconductor, etc., from molten silicon.

### DISCUSSION OF THE BACKGROUND

As one of the causes that a dislocation is formed in silicon single crystal during pulling up of the crystal, it has been known that cristobalite formed on the inside surface of the quartz glass crucible is released into the molten silicon. It is also known that a process, in which an alkaline earth metal is coated on the inside surface of the crucible as a crystallization promoter to form cristobalite layer on the inside surface of the crucible at an early stage of the pulling up (e.g. U.S.PAT. No.5,976,247 or Japanese Pat. No.3100836) is a counter measure to this problem. In these inventions, a barium hydroxide solution etc. is coated on the surface of the quartz glass crucible and the coated barium hydroxide reacts with carbon dioxide in air to form barium carbonate on the surface of the crucible. Then, the formed barium carbonate is weakly adhered on the surface of the crucible by drying it and is used as the crystallization promoter.

However, the alkaline earth metals, beryllium, magnesium, calcium, and strontium, have a large segregation coefficient, so that there is a fatal problem that these metals can be easily included in the single crystal silicon to significantly reduce its semiconductor property remarkably. Moreover, although barium has a small segregation coefficient, there is also a problem that the handling is difficult since its toxicity is high. Therefore, a quartz glass crucible having a surface layer which contains elements selected from zirconium, niobium, hafnium, tantalum, and rare earth elements, is also proposed (Japanese Patent Laid Open No.2002-29890) instead of the alkaline earth metal.

However, there are the following problems in the above-described strategy.

That is, regarding the former quartz glass crucible, (A) since the barium carbonate powder on the surface of the crucible is only weakly adhered without any binder etc., the adhesion strength of the powder is so weak that the barium carbonate powder is abraded easily to a non-uniform adhesion state. Moreover there is also a possibility that the worker's health is negatively affected because the barium carbonate powder is scattered. In addition, (B) the adhesion amount of barium carbonate becomes excessive easily. Furthermore, (C) if the crucible is washed, the barium carbonate powder adhered on the surface of the crucible is washed away. Therefore it is impossible to wash the crucible after the adhesion of the barium carbonate powder, even if some contaminants adhere on the surface of the crucible.

Moreover, regarding the latter quartz glass crucible, the surface modified layer is formed in a process wherein a coating liquid comprising a metal oxide dispersed in a sol state, is coated on the surface of the crucible and dried at 150°C in the atmosphere. However, the surface modified layer baked on the surface of the crucible cannot be formed by the heat-treatment at such low temperature, so that the problem, i.e., the surface layer is abraded easily, cannot be solved.

WO-A-94/24505 teaches silica crucibles in which a metal oxide film is formed on the inner surface. The metal oxide film may be produced from *inter alia* magnesium oxide or calcium oxide. The film is formed by pyrolitic deposition at 600-1,500°C of a respective organometallic compound.

### SUMMARY OF THE INVENTION

The present invention solves these problems concerning the conventional quartz glass crucible, and provides a process for surface modifying a quartz glass crucible to form a coated layer having sufficient adhesive strength and durability.

According to the present invention, there is provided a process for surface modifying a quartz glass crucible comprising the steps of:
coating a coating liquid containing a metal salt on at least a portion of the inside and/or outside surface of said crucible, the metal content of the coating liquid being 0.01-15 weight % calculated as the metal oxide,
drying said coated liquid, and
baking said dried coated liquid at a temperature of 400-1200°C and which is higher than the thermal decomposition temperature of said metal salt to bake a coated layer of the metal oxide on said surface of said crucible.

Preferably the metal salt is one or more organic acid salts of magnesium, calcium, strontium or barium. It is further preferred that the organic acid is a carboxylate. It is further preferred that the carboxylate has the formula CₙH₂ₙ₊₁COO, where n is an integer of 3 to 7. It is further preferred that the carboxylate is derived from n-butyric acid, α-methyl butyric acid, iso-valeric acid, 2-ethyl butyric acid, 2.2-dimethyl butyric acid, 3.3-dimethyl butyric acid, 2.3-dimethyl butyric acid, 3-methyl pentanoic-acid, 1.4-methyl pentanoic-acid, 2-ethyl pentanoic-acid, 3-ethyl pentanoic-acid, 2.2-dimethyl pentanoic-acid, 3.3-dimethyl pentanoic acid, 2.3-dimethyl pentanoic acid, 2-ethyl hexanoic acid or 3-ethyl hexanoic acid.

Preferably, the dried coating liquid is baked for 10 to 120 minutes.

It is further preferred that the coating liquid comprises from 0.5 to 10 weight % of metal based on the amount of the metal oxide.

The coating liquid preferably comprises an organic solvent selected from an ester, an alcohol, a ketone, a hydrocarbon or a mixture of any thereof. In this case, the solvent is preferably toluene.

The surface modified quartz glass crucible produced by the process of the present invention has a coated layer of metal oxide on the whole or a part of the inside and/or outside surface of the crucible. This metal oxide acts as a crystallization promoter to the surface glass layer of the crucible, at the high temperature in the process of pulling up the silicon single crystal. Therefore, when the crucible is used for silicon single crystal production, a uniform cristobalite layer is formed on the inside surface of the crucible at an early stage of pulling up, and as a result a high dislocation free ratio of pulled crystal can be obtained. Moreover, the strength of the crucible under the high temperature is increased by the uniform cristobalite layer formed on the inside or outside surface of the crucible.

Moreover, since the coated layer is baked on the surface of the crucible, it is very stable and has high durability. Therefore, there is no abrasion when contacted with the instruments or persons and no problem that the adhesion state of the metal oxide in the coated layer becomes non-uniform. In addition, even if the coating layer is comparatively thin, since the uniform cristobalite layer is formed on the surface of the crucible during pulling up the single crystal, the dislocation free ratio of silicon can be increased. On the other hand, regarding the conventional quartz crucible having an adhered barium carbonate powder on its surface, since the adhesion strength of the barium carbonate powder is very weak, the powder can be washed away easily by water washing. Therefore, it is impossible to wash the crucible even if some contaminants are adhered on the surface of the crucible. While regarding the surface modified quartz glass crucible of the present invention, since the coated layer is baked on the surface of the crucible, it dose not be washed away during the water washing,so that the contaminants on the surface of the crucible can be removed easily.

### DETAILED DESCRIPTION OF THE PREFERRED EMBODIMENT

Hereafter, the invention is explained concretely according to the preferred embodiment.

The surface modified quartz glass crucible produced by the process of the present invention is a quartz glass crucible for silicon single crystal production. The quartz glass crucible has a coated layer of the metal oxide baked on the whole or a part of the inside and/or outside surface of the crucible. Moreover, it is preferable that the surface modified quartz glass crucible has a coated layer of the metal oxide baked on at least the inside surface of the crucible, in which the metal oxide comprises one or more kinds of oxide of magnesium, calcium, strontium, or barium.

The coated layer containing the metal oxide can be formed by adhering a solution of a metal organic acid salt, such as a salt of magnesium, calcium, strontium or barium, and baking this solution at a higher temperature than the decomposition temperature of these salts. The most preferable of the above-mentioned metal organic acid salts is carboxylate. As an acyloxy group to form the carboxylate, the materials indicated by the general formula CₙH₂ₙ₊₁COO, where n is integer of 3 to 7, are preferable. Concretely, the acyloxy group from n-butyric acid, α-methyl butyric acid, iso-valeric acid, 2-ethyl butyric acid, 2.2-dimethyl butyric acid, 3.3-dimethyl butyric acid, 2.3-dimethyl butyric acid, 3-methyl pentanoic-acid, 1.4-methyl pentanoic-acid, 2-ethyl pentanoic-acid, 3-ethyl pentanoic-acid, 2.2-dimethyl pentanoic-acid, 3.3-dimethyl pentanoic acid, 2.3-dimethyl pentanoic acid, 2-ethyl hexanoic acid, or 3-ethyl hexanoic acid, etc., can be used suitably.

It is preferable that these organic acid salts are dissolved in an organic solvent. As a suitable organic solvent, an ester and/or an alcohol, or the mixed solvent, where carboxylic acid is further mixed to the ester and / or the alcohol, can be used. As the ester of the organic solvent, ethyl acetate, propyl acetate, n-butyl acetate, sec-butyl acetate, tert-butyl acetate, isobutyl acetate, n-amyl acetate, sec-amyl acetate, tert-amyl acetate, and iso-amyl acetate, are preferable.

As alcohols, methanol, ethanol, 1-propanol, 2-propanol, 1-butanol, 2-butanol, iso-butyl alcohol, 1-pentanol, 2-pentanol, 2-methyl-2-pentanol, and iso-amyl alcohol, etc., are suitable. In alcohols, an alkoxy alcohol, i.e., the alcohol containing an ether group, is included. As the example of this kind of alcohols, 2-methoxyethanol and 1-methoxy-2-propanol can be used. Moreover, as examples of usable solvents, ketones, such as acetone, ethylmethylketone and methylsiobutylketone, and hydrocarbons, such as toluene, xylene, hexane and cyclohexane, etc., can be mentioned. It is usable to mix two or more kinds of these solvents.

It is preferable that the amount of the metal oxide on the surface of the crucible is 1 × 10⁻⁹ to 1 × 10⁻⁶ mol/cm². In order to coat this amount of the metal oxide, the amount of the metal component in the coating liquid is 0.01 to 15 weight %, which is calculated as an oxide, and 0.5 to 10 weight % is preferable. When the amount of the metal component is less or more than said range, it is not preferable that the amount of the metal oxide on the surface of the crucible becomes less or more easily. In addition, when the amount of the metal oxide is less than 1 × 10⁻⁹ mol/cm², the crystallized layer cannot be uniform, and when the amount of the metal oxide is more than 1 × 10⁻⁶ mol/cm², the crystallized layer becomes too thick and is abraded easily.

The coating liquid, such as said metal organic acid salt solution, is coated on the whole or a part of the inside and / or outside surface of the crucible. As the process for coating, a spray method, and a dipping method, etc. can be used. These coating processes are not limited. In addition, the coated area on the surface of the crucible can be on a part or the whole of the inside surface, or can be on a part or the whole of the outside surface, or can be on a part or whole of both the inside and outside surface. Moreover, in order to increase the dislocation free ratio of the pulled crystal by crystallizing the inside surface of the crucible during pulling up said crystal, it is necessary to coat at least the whole or a part of the inside surface of the crucible.

After coating the coating liquid on the surface of the crucible, the baking is done at a higher temperature than the thermal decomposition temperature of the metal salt. The baking temperature changes with the kinds of the metal compounds, although, it is carried out at 400 to 1200°C for preferably 10 to 120 minutes. In addition, as the barium oxide coated layer shown in Example, a coated layer baked at more than 600°C for 30 minutes is preferable. When the baking temperature is too low, the coated layer cannot be baked on the surface of the crucible. Moreover, the baking temperature is more than 1200°C, the crucible is devitrified. Baking at the suitable temperature forms a transparent coated layer of metal oxide of the metal. This coated layer is baked on the surface of the crucible, so that the coated layer is not abraded by contact with the surface.

Regarding the quartz glass crucible having said coated layer on its inside surface, the cristobalite layer is formed uniformly on its inside surface by the crystallization promoting action of the metal oxide, such as barium etc., when the crucible is heated during pulling up of the single crystal. As the result, the dislocation free ratio of the pulled crystal is increased. Moreover, regarding the quartz glass crucible having a coated layer on its outside surface, since the surface of the peripheral wall of said crucible is crystallized, the strength of the crucible at high temperature heating is increased, so that the deformation of the crucible can be prevented.

### EXAMPLE

Hereafter, the present invention is explained with examples which are not intended to further limit the invention.

### Example 1

A coating liquid comprising the toluene solution of 2-ethylhexanoic barium was sprayed to coat on the whole of the surface of a quartz glass crucible and a layer was formed by heating the coated liquid at the temperatures and times shown in Table 1. The crucible was made by an arc fusion rotating mold method, which is generally used in the process to produce the crucible for pulling up a single crystal.

Moreover, regarding the below-described quartz glass crucibles, the comparative examples are shown in Table 1. They include a crucible that was sprayed similarly but the baking temperature was not sufficiently high (No.7), a crucible that was not coated (No.8), and a crucible in which barium carbonate powder was adhered by the conventional method but was not baked, (No.9).

Regarding said quartz glass crucibles, the strength of the coated layer was evaluated according to the specification standard (JIS 5600-5-4).

This evaluation was done by scratching method using the marketed pencil (the trade name was Mitsubishi UNI). These results were shown in Table 1. Regarding the coated layers baked at more than 600°C using the coating liquid having more than 0.01 weight % of the barium content (No.1 to No.5), the scratching did not appear on the coated layer by using a pencil of hardness 6H. In addition, regarding the coated layer baked at more than 400°C (No.6), although the thin trace of the scratching appeared by using a pencil of hardness 6H, the scratching did not appear by using a pencil of hardness 5H. On the other hand, regarding the coated layer baked at 200°C (No.7), since the baking was not sufficient, the scratching appeared by using a pencil of hardness 3H. Moreover, regarding the conventional coated layer (No.9), which was not baked and the barium carbonate powder was only adhered on the surface, the scratching appeared by using the pencil of hardness 3H.

Next, regarding said quartz glass crucibles, the washing tests were carried out. These tests were conducted by measuring the amount of the residual metal oxide on the surface of the crucible after washing with pure water and drying. These results were also shown in Table 1. Regarding the quartz glass crucibles (No.1 to 6), in which the coated layers were formed under the suitable conditions of the present invention, barium was nealy unaffected by washing, and the adhesion amounts were not changed substantially. On the other hand, regarding the coated layer baked at 200°C (No.7 not according to invention), since the baking was not sufficient, the adhesion amount of barium was decreased to less than a half by washing. Moreover, regarding the conventional adhered layer (No.9), since barium carbonate was not baked, almost all barium was washed away.

Furthermore, regarding said quartz glass crucibles, the pulling up tests of the single crystal silicon were carried out. The dislocation free ratios of the single crystal, are shown in Table 1. (The dislocation free ratio is defined as kilograms of dislocation free single crystal per kilograms of polysilicon charged to the crucible.) Regarding the quartz glass crucible (No.1 to No.6), where the coated layers were formed under the conditions of the present invention, since cristobalite layers having the sufficient layer thickness were formed also with comparatively little barium amount, a high dislocation free ratio can be obtained. On the other hand, regarding the quartz glass crucible having the coated layer baked at 200°C (No.7), the cristobalite layer was thin, and the dislocation free ratio was remarkably low. In addition, regarding the conventional quartz glass crucible (No.8), which dose not have a coated layer, there was no crystallization layer, and regarding the conventional quartz glass crucible (No.9), where the barium carbonate powder was adhered, the cristobalite layer was thin. Therefore, the dislocation free ratio of these tests (No.8 and 9), were remarkably low.

### Example 2

Regarding the quartz glass crucible having the coated layer shown in No.3 in Table 1, a multi-pulling test was carried out, in which the pulling up of the silicon single crystal was repeated by charging the polysilicon into the crucible again after the pulling up the single crystal. In addition, said recharging was done without lowering temperature. These results were shown in Table 2. Moreover, the result of the comparison test of the conventional quartz glass crucible having the barium carbonate powder (No.9) in Table 1, is also shown in Table 2.

**[Table 1]**

| No. | Coating Liquid | | Baking | | Hardness by Pencil | Adhesion Amounts of Barium Oxide | | Pulling up Single Crystal | |
|---|---|---|---|---|---|---|---|---|---|
| | Metal Kinds : Amounts | Solvent | °C | Minutes | | Before Washing | After Washing | Yield % | Crystal Layer Thickness |
| 1 | Ba : 1 | Toluene | 850 | 30 | No Cracking by 6H | 52 | 52 | 82 | 130 |
| 2 | Ba : 0.1 | Toluene | 850 | 30 | | 15 | 15 | 84 | 110 |
| 3 | Ba : 0.01 | Toluene | 850 | 30 | | 1 | 1 | 85 | 80 |
| 4 | Ba : 0.01 | Toluene | 700 | 30 | | 1 | 1 | 81 | 70 |
| 5 | Ba : 0.01 | Toluene | 600 | 30 | | 1 | 1 | 81 | 65 |
| 6 | Ba : 0.01 | Toluene | 400 | 30 | No Cracking by 5H | 1 | 0.9 | 80 | 60 |
| 7 | Ba : 0.01 | Toluene | 200 | 30 | Cracking appeared by 3H | 1 | 0.3 | 55 | 10 |
| 8 | Non-surface Treatment | | | | | 0 | 0 | 35 | 0 |
| 9 | Conventional Crucible Having Ba Carbonate Powder | | | | Cracking appeared by 3H | 1 | 0.3 | 55 | 10 |

| | | | | | | | | | |
|---|---|---|---|---|---|---|---|---|---|
| (Note) Metal Amounts in Coating Liquid (Ba Amounts) are Amounts calculated as an oxide (wt%), Yield is dislocation free ratio, Crystal Layer Thickness is µm, and Adhesion amounts of Barium Oxide is Amounts calculated as Barium Oxide in µg/cm². | | | | | | | | | |

Regarding the quartz glass crucible having the coated layer of the present invention (No.3), a cristobalite layer was formed uniformly on the inside surface of the crucible by the crystallization promoter contained in the coated layer, and the releasing of cristobalite did not occur. Therefore, even when the pulling up the single crystal was repeated 4 times, a high dislocation free ratio, which was the level of 80%, was kept. As a result, the crucible life was prolonged. On the other hand, regarding the conventional quartz glass crucible having the adhered barium carbonate powder (No.9), the cristobalite was deposited non-uniformly and partially as the pulling up was repeated. The frequency of cristobalite releasing to the molten silicon, increases, so that the dislocation free ratio was decreased gradually. In addition, regarding the crucible, in which the pulling up of the single crystal was repeated 4 times, the cristobalite layer was not identified on the surface of the crucible. By the way, regarding the conventional quartz glass crucible having the adhered barium carbonate powder (No.9), it is necessary that the amount of adhered barium is more than 20 µg /cm² for obtaining the multi-pulling effect, which was the same as the present invention. When such a large amount of barium is adhered on the surface of the crucible, it cannot be avoided to negatively influence the quality of the single crystal silicon.

**[Table 2]**

| [Dislocation Free Ratio %] | | | | |
|---|---|---|---|---|
| Number of Times of Pulling up | 1 | 2 | 3 | 4 |
| Coated Crucible | 87 | 86 | 84 | 84 |
| Conventional Crucible Having Adhered Barium Carbonate Powder | 55 | 50 | 47 | 42 |

Regarding the quartz glass crucible produced by the process of the present invention, the coated layer containing the metal oxide having the crystallization promoting effect, is formed on the surface of the crucible to become integrated structure by baking, so that there is no abrasion. Therefore, the adhesion state of the metal oxide in the coated layer can be kept uniform, and the cristobalite can be formed uniformly on the surface of the crucible during the pulling up the single crystal, so that a high dislocation free ratio can be obtained. In addition, since the coated layer is not abraded easily by contacting the crucible, there is no conventional problem that the fine barium carbonate powder is scattered whenever the case containing the crucible is opened.

## Claims

1. A process for surface modifying a quartz glass crucible comprising the steps of:
coating a coating liquid containing a metal salt on at least a portion of the inside and/or outside surface of said crucible, the metal content of the coating liquid being 0.01-15 weight % calculated as the metal oxide,
drying said coated liquid, and
baking said dried coated liquid at a temperature of 400-1200°C and which is higher than the thermal decomposition temperature of said metal salt to bake a coated layer of the metal oxide on said surface of said crucible.

2. A process according to Claim 1, wherein the metal salt is one or more organic acid salts of magnesium, calcium, strontium or barium.

3. A process according to Claim 2, wherein the organic acid salt is a carboxylate.

4. A process according to Claim 3, wherein the carboxylate has the formula CₙH₂ₙ₊₁COO, where n is an integer of 3 to 7.

5. A process according to Claim 4, wherein the carboxylate is derived from n-butyric acid, α-methyl butyric acid, iso-valeric acid, 2-ethyl butyric acid, 2.2-dimethyl butyric acid, 3.3-dimethyl butyric acid, 2.3-dimethyl butyric acid, 3-methyl pentanoic-acid, 1.4-methyl pentanoic-acid, 2-ethyl pentanoic-acid, 3-ethyl pentanoic-acid, 2.2-dimethyl pentanoic-acid, 3.3-dimethyl pentanoic acid, 2.3-dimethyl pentanoic acid, 2-ethyl hexanoic acid or 3-ethyl hexanoic acid.

6. A process according to Claim 1, wherein the dried coating liquid is baked for 10 to 120 minutes.

7. A process according to Claim 1, wherein the metal content of the coating liquid is 0.5 to 10 weight % calculated as the metal oxide.

8. A process according to Claim 1, wherein the coating liquid comprises an organic solvent selected from an ester, an alcohol, a ketone, a hydrocarbon or a mixture of any thereof.

9. A process according to Claim 8, wherein the solvent is toluene.

## Patentansprüche

1. Verfahren zur Oberflächenmodifikation eines Quarzglastiegels, das die folgenden Schritte umfasst:
Auftragen einer metallsalzhaltigen Beschichtungsflüssigkeit auf mindestens einen Teil der Innen- und/oder Außenoberfläche des Tiegels, wobei der Metallgehalt der Beschichtungsflüssigkeit, bezogen auf die Metalloxide, 0,01 bis 15 Gew.% ist,
Trocknen der aufgetragenen Flüssigkeit und
Brennen der getrockneten und aufgetragenen Flüssigkeit bei einer Temperatur von 400 bis 1.200°C, die höher ist, als die Zersetzungstemperatur des Metallsalzes, um eine Beschichtung der Metalloxide auf die Oberfläche des Tiegels zu brennen.

2. Verfahren gemäß Anspruch 1, wobei das Metallsalz ein oder mehrere organische Säuresalze von Magnesium, Calcium, Strontium oder Barium ist.

3. Verfahren gemäß Anspruch 2, wobei das organische Säuresalz ein Carboxylat ist.

4. Verfahren gemäß Anspruch 3, wobei das Carboxylat die Formel CₙH₂ₙ₊₁COO aufweist, in der n eine ganze Zahl von 3 bis 7 ist.

5. Verfahren gemäß Anspruch 4, wobei das Carboxylat abgeleitet ist von n-Buttersäure, α-Methylbuttersäure, Isovaleriansäure, 2-Ethylbuttersäure, 2,2-Dimethylbutersäure, 3,3-Dimethylbuttersäure, 2,3-Dimethylbuttersäure, 3-Methylpentansäure, 1,4-Methylpentansäure, 2-Ethylpentansäure, 3-Ethylpentansäure, 2,2-Dimethylpentansäure, 3,3-Dimethylpentansäure, 2,3-Dimethylpentansäure, 2-Ethylhexansäure oder 3-Ethylhexansäure.

6. Verfahren gemäß Anspruch 1, wobei die getrocknete Beschichtungsflüssigkeit für 10 bis 120 Minuten gebrannt wird.

7. Verfahren gemäß Anspruch 1, wobei der Metallgehalt der Beschichtungsflüssigkeit, bezogen auf die Metalloxide, 0,5 bis 10 Gew.% ist.

8. Verfahren gemäß Anspruch 1, wobei die Beschichtungsflüssigkeit ein organisches Lösungsmittel umfasst, das aus einem Ester, einem Alkohol, einem Keton, einem Kohlenwasserstoff oder einer Mischung aus irgendeiner dieser Verbindungen ausgewählt ist.

9. Verfahren gemäß Anspruch 8, wobei das Lösungsmittel Toluol ist.

## Revendications

1. Procédé de modification de surface d'un creuset en verre de quartz comprenant les étapes de :
enduction d'un liquide d'enduction contenant un sel de métal sur au moins une partie de la surface intérieure et/ou extérieure dudit creuset, la teneur en métal du liquide d'enduction étant 0,01 à 15% en poids calculée comme l'oxyde de métal,
séchage dudit liquide enduit, et
cuisson dudit liquide enduit séché à une température de 400 à 1 200°C et qui est supérieure à la température de décomposition thermique dudit sel de métal pour cuire une couche enduite de l'oxyde de métal sur ladite surface dudit creuset.

2. Procédé selon la revendication 1, dans lequel le sel de métal est un ou plusieurs sel(s) acide(s) organique(s) de magnésium, de calcium, de strontium ou de baryum.

3. Procédé selon la revendication 2, dans lequel le sel acide organique est un carboxylate.

4. Procédé selon la revendication 3, dans lequel le carboxylate a la formule CₙH₂ₙ₊₁COO, où n est un entier de 3 à 7.

5. Procédé selon la revendication 4, dans lequel le carboxylate est obtenu à partir d'acide n-butyrique, d'acide α-méthylbutyrique, d'acide isovalérique, d'acide 2-éthylbutyrique, d'acide 2,2-diméthylbutyrique, d'acide 3,3-diméthylbutyrique, d'acide 2,3-diméthylbutyrique, d'acide 3-méthylpentanoïque, d'acide 1,4-méthylpentanoïque, d'acide 2-éthylpentanoïque, d'acide 3-éthylpentanoïque, d'acide 2,2-diméthylpentanoïque, d'acide 3,3-diméthylpentanoïque, d'acide 2,3-diméthylpentanoïque, d'acide 2-éthylhexanoïque ou d'acide 3-éthylhexanoïque.

6. Procédé selon la revendication 1, dans lequel le liquide d'enduction séché est cuit pendant 10 à 120 minutes.

7. Procédé selon la revendication 1, dans lequel la teneur de métal du liquide d'enduction est 0,5 à 10% en poids calculée comme l'oxyde de métal.

8. Procédé selon la revendication 1, dans lequel le liquide d'enduction comprend un solvant organique choisi parmi un ester, un alcool, une cétone, un hydrocarbure ou un mélange de quelconques de ceux-ci.

9. Procédé selon la revendication 8, dans lequel le solvant est le toluène.
